# EUROPEAN PATENT SPECIFICATION

(11) **EP 0 558 061 B1**
(45) Date of publication and mention of the grant of the patent: **09.08.2000**
(21) Application number: 93103108.2
(22) Date of filing: 26.02.1993
(51) Int. Cl.: C23C 14/02

(54) **Improvements in physical vapour deposition processes**
Verbesserungen von Verfahren der physikalischen Dampfphasen-Abscheidung
Perfectionnements apportés au procédé de dépôt physique en phase gazeuse

(30) Priority: 27.02.1992 DE 4206110; 19.03.1992 DE 4208939
(43) Date of publication of application: 01.09.1993
(73) Proprietor: HAUZER INDUSTRIES BV, 5900 AE Venlo (NL)
(72) Inventor: Münz, Wolf-Dieter, NL-5913 RV Venlo (NL)
(74) Representative: Manitz, Finsterwald & Partner

(56) References cited:
- EP-A- 0 320 706
- EP-A- 0 401 488
- WO-A-91/00374

## Description

The invention relates to a method for coating a substrate with a hard material layer consisting of at least one of TiN, TiCN, ZrN, ZrCN, HfN, HfCN, TiAlN, TiAlCN, TiZrN, TiZrCN, TiNbN, TinBCN, CrN and CrCN by a physical vacuum deposition process.

A method of this kind is known from WO-A-9100374 describing a process for depositing a hard material coating such as TiN in which an enrichment of the substrate surface is done with Nb or Ta ions, using a vacuum arc evaporation using a vacuum arc evaporation method. By this known method only a transition layer is formed which usually has a thickness of about 1500 to 2000 Å.

EP-A-320 706 discloses a method for depositing by physical vapor deposition, either by sputtering or arc evaporation, a layer of Ta and/or Nb before depositing the arc material coating. Also in this known method one only proposes the use of a transition layer which does not lead to anti-corrosion properties as requested for many technical purposes.

It is known that customary hard material layers such as TiN, TiCN, ZrN, ZrCN, CrN etc. produced by physical vapour deposition are characterised in acqueous acidic solutions by a pronouncedly positive electrochemical potential. In contrast, typical substrate materials on which hard material layers are applied, for example Fe, FeNiCr, Ni, Cr, Cu, CuZn have negative electrochemical potentials.

These "natural" circumstances give rise to the problem that localised electrochemical cells or electrochemical local elements can form under certain conditions which necessarily lead to localised corrosion in the substrate material. These conditions exist in the presence of a pore in a hard material layer and in the presence of moisture and, for example, traces of halogen ions. Moisture and halogen ions can for example arise during handling, for example due to perspiration, e.g. deposited by finger or hand prints.

It is known today that one can extensively suppress this localised corrosion if one provides the substrate surface with an electrochemically positive covering layer. It is known, for example, to apply a 0.1 µm to 2 µm thick galvanic NiPd layer, with the noble metal Pd functioning as a positive potential generator. This method is however expensive having regard to the high proportion of the noble metal component.

The materials such as Ta and Nb, which are particularly chemically resistant, are supposed to be particularly well suited as an intermediate layer between the metal substrate and the ceramic hard material layer. If one namely uses an intermediate layer of this kind then, in the case of a pore in the hard material layer, and in the presence of acidic aqueous media, electrically non-conductive oxides Ta₂O₅ form directly beneath the pore. These oxides can only be attacked by hydrofluoric acid solutions. The system thus has a self-healing character.

It is, however, problematic that this proposal can only be realised, in particular industrially realised, with great difficulty because neither Ta nor Nb can be deposited simply and in dense thin layers. It is known that Ta and Nb can also not be deposited using aqueous galvanic processes.

The problem to be solved by the present invention is to confer good anti-corrosion properties to hard material coating substrate systems.

This problem is solved by a method comprising the features of claim 1. Preferred embodiments of this method are described in the subclaims.

In the process of the present invention the surface of the substrate is first enriched by means of the arc process during the known etching step, in the multiply ionised metallic vapour of Ta and Nb, with atoms of Ta or Nb.

After this pretreatment the substrate, or the part to be coated, is coated with a layer which preferably amounts to from 0.05 µm to ca. 2 µm from the above-named material systems, i.e. the elements Ta or Nb. For the coating process either the arc technique or the sputtering process can be considered. The further coating with a hard material layer, for example TiN, ZrN etc., then takes place on this intermediate layer.

The invention will now be explained in further detail with reference to Figs. 1 to 6. It shows
- Fig. 1: a diagram of the typical distribution of the kinetic energies of the particles which are incident on the substrate when coating a substrate by means of a customary arc discharge vaporisation method,
- Fig. 2: basic circuit diagrams to explain the arc discharge vaporisation and cathod sputtering processes,
- Fig. 3: a schematic illustration of an apparatus for carrying out the process,
- Fig. 4: an example of the process steps in a schematic illustration,
- Fig. 5: is a longitudinal sectional view taken along lines A-A of Fig. 6, and
- Fig. 6: is a sectional view taken along lines B-B of Fig. 5.

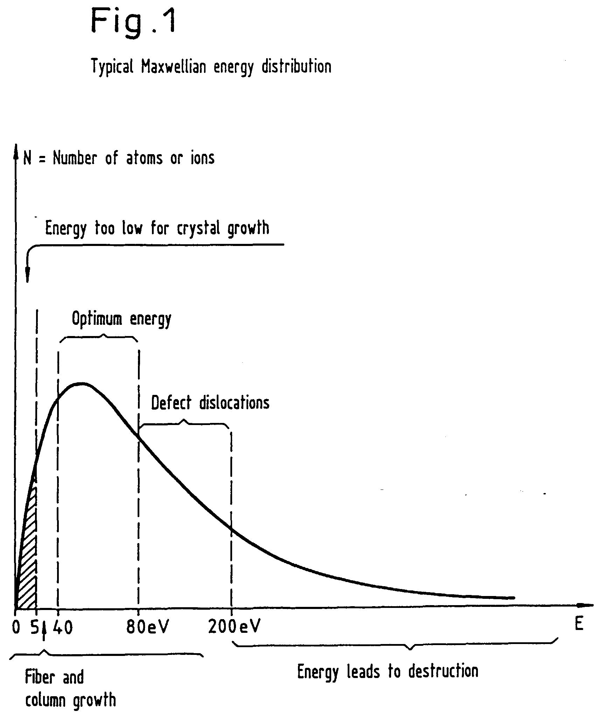

The diagram of Fig. 1 shows the typical distribution of the kinetic energies of the particles which are incident on a substrate to be coated such as resuit with a coating produced by means of a customary arc discharge vaporisation method. The kinetic energy is recorded on the abscissa and the frequency of incidence of the condensing particles is recorded on the ordinate.

As can be seen from this diagram the ideal energy range lies, in accordance with experience, at around 40 to 80 eV. Smaller or larger energies lead to defect mechanisms which are set forth in the diagram.

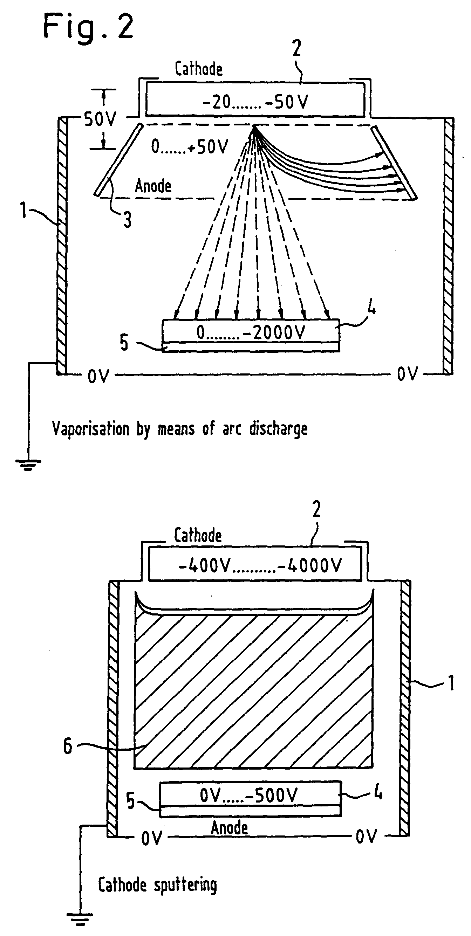

Basic circuit diagrams for arc discharge vaporisation and for cathode sputtering are shown in Fig. 2.

A cathode 2 is arranged in the container 1. In the case of arc discharge vaporisation this cathode lies at a potential of -20 V to -50 V. The arc current forms between the cathode 2 and the anode 3.

The anode lies at a typical potential in the region between 0 and +50 V. The arc current can amount to several hundreds of amperes. A part of the current propagates in the space in the direction towards the substrates 4. These substrates lie, as required, at a negative bias of up to 2000 V in the case of an etching process and, for example, between 1100 and 1200 V in the case of forming the transition layer, or at ca. 100 V during coating.

The substrates are fixedly connected to the substrate holder 5, the latter is built into the chamber 1 in electrically insulated manner and can be connected with a suitable power supply.

In the case of conventional cathode sputtering the negative bias lies at 3000 to 4000 V. Typical values for magnetron sputtering lie between 400 and 700 V. The space filling plasma of the conventional cathode sputtering process is indicated schematically with the reference numeral 6. The same conditions apply to the substrates 4 and the substrate holder 5 as in the case of arc discharge vaporisation.

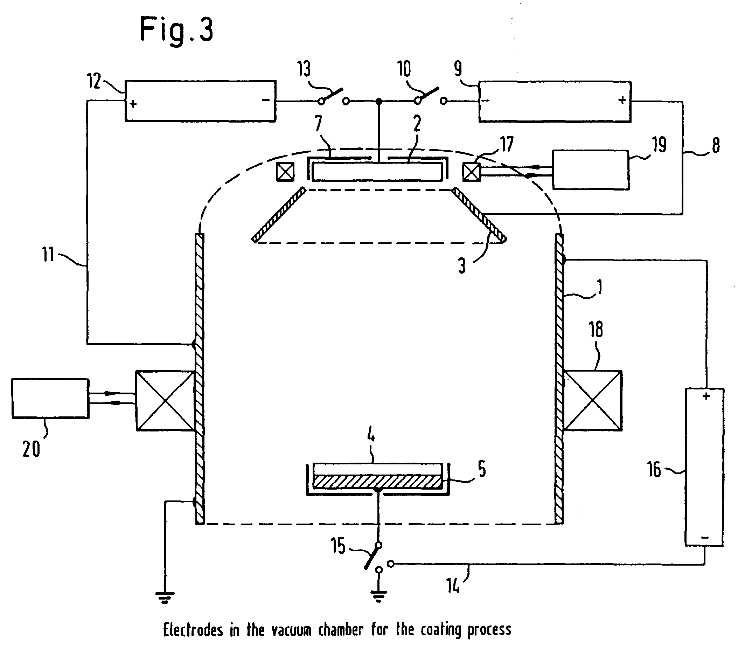

Fig. 3 shows a block diagram of an example of an apparatus for carrying out the invention. In this arrangement a common cathode 2 is provided for the arc discharge vaporisation and for the cathode sputtering.

The cathode 2 is surrounded by a dark field screen lying at earth potential or at a floating potential, or by insulation material 7. Cathode 2 and anode 3 are connected together in the circuit 8. The power supply 9 for maintaining the arc discharge and the switch 10 for selectively actuating the arc discharge vaporisation lie in this power circuit.

Parallel to the power circuit 8 lies the power circuit 11 which connects the power supply 12 to the cathode 2 via the switch 13 for selective maintenance of the cathode sputtering discharge. The positive output of the power supply 12 lies in known manner at earth potential. Finally, a circuit 14 connects the substrate holder 5 with the negative output of the power supply 146 via a switch 15. The positive output lies in this case either at earth potential or at the potential of the chamber. Two possible embodiments of magnetisation devices for the plasma (reference numeral 6 in Fig. 2) are indicated by the reference numerals 17 and 18. Depending on the technical realisation these magnetisation devices 17 and 18 consisting of scattering field coils are electrically connected with the DC supplies 19 and 20 respectively. The level of the coil current is to be selected in this arrangement such that the ion current density at the substrates 4 lies above 2 mÅ/cm² under the action of the negative bias originating from the power supply 16.

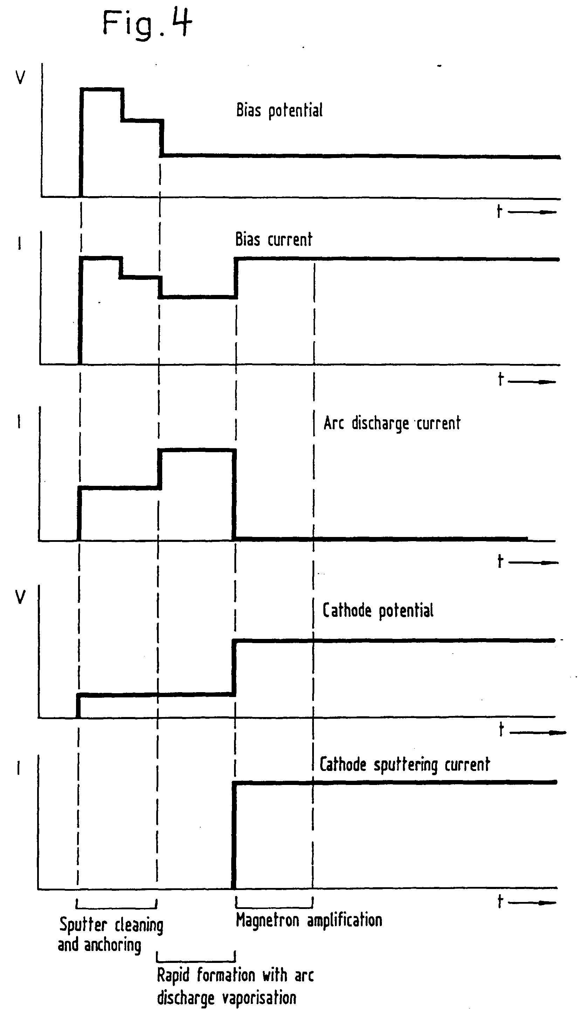

Fig. 4 schematically reproduce the individual process steps and shows the time sequence of the characteristic electrical method parameters in a schematic representation.

During the etching process the bias potential at the substrate is at its highest (typically -1600 V) and is reduced stepwise to form the transition zone (typically -1100 V) and during coating with the aid of the power supply 16. The current at the substrates is initially very high and is reduced during the formation of the transition layer.

During the coating by means of arc discharge vaporisation, as also during the phase of cathode sputtering, the negative substrate bias can be held at a constant level, namely typically 50 V ± 25 V.

To achieve an adequate ion current at the substrate the arc current (power supply 9) is increased.

The cathode potential is kept almost constant (typically -20 V) during the first process steps by means of the power supply 9 and is increased or set by means of the power supply 12 to typically -500 V during the coating by cathode sputtering, for example when using magnetron cathodes.

The cathode current during cathode sputtering is current controlled (power supply 12) and remains constant during the course of the further coating process.

The ion current to the substrates (bias current) is correspondingly high through the use of additional magnetic ionisation (for example by means of the magnetising devices 17, 18) and lies above 2 mÅ/cm².

The most important process parameters are set forth in the following table:

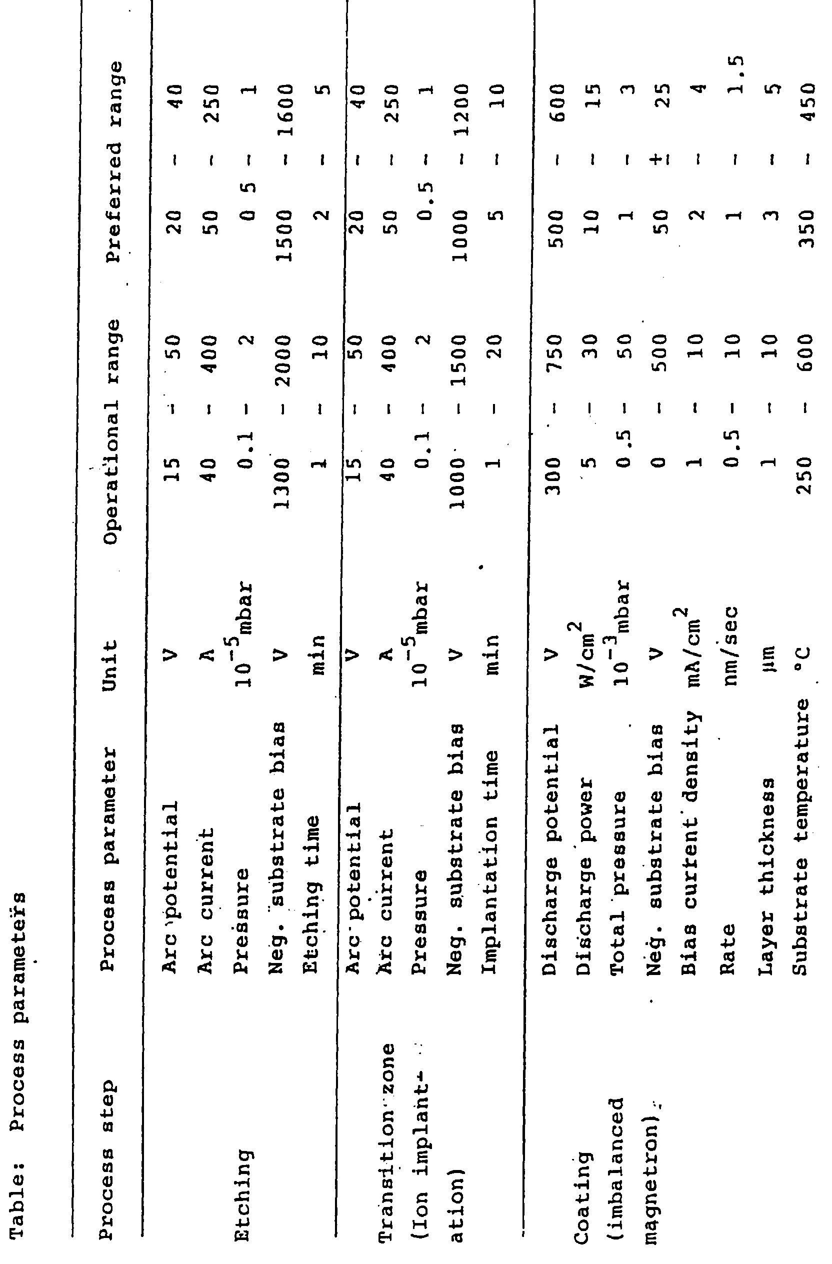

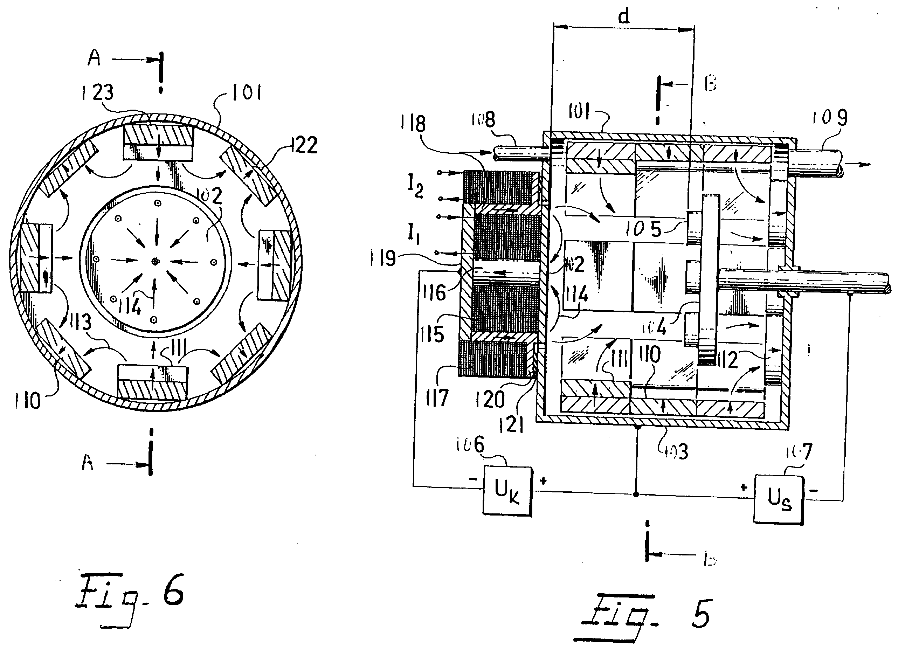

Further useful apparatus for practising the present invention will now be explained with reference to Figs. 5 and 6.

Figs 5 and 6 schematically represent a device equipped with two electromagnets behind a circular cathode. The device consists of chamber 101, which is a vacuum chamber made of a magnetically soft metal and is cylindrical in shape, with its axis oriented horizontally. Chamber 101 also serves as anode 103. Chamber 101 is equipped with inlet 108 which provides working gas and pumping outlet 109. Flush with one vertical wall of chamber 101 and coaxial with it, is a flat circular cathode 102 made of titanium. Circular holder 104 for substrates 105 is fastened coaxial to chamber 101 and opposite cathode 102; holder 104 is adjustably fastened such that the distance between holder 104 and cathode 102 can be varied from 30 to 300 mm. Source 106 of cathode voltage U_{K} and source 107 of substrate voltage U_{S} are placed outside chamber 101. Source 106 of voltage U_{K} is a source of direct-current voltage from zero to 1,000 V and is connected with its negative pole to cathode 102 and its positive pole to chamber 101. Source 107 of direct-current voltage U_{S}, variable from zero to 1,000 V, is connected with its negative pole to conductive holder 104 and its positive pole to chamber 101. Sources of the multipolar magnetic holding field are, in part, permanent magnets 110, 111, 112, and, in part, two electromagnets 115, 117.

As seen in Fig. 5, permanent magnets 110, 111 are accommodated and fastened on the inner surface of chamber 101 in groups 122, 123 which form an even number of rows, eight are shown in Fig. 5, parallel with the device's axis. All the magnets in a given group have congruent orientations and have radial directions. The magnets of adjacent groups 122, 123 have opposite polarity orientations. For this purpose, magnets 111 closer to cathode 102 are doubled in one orientation. Permanent magnets 112 are further accommodated on the chamber's inside vertical wall behind the substrates and their poles are oriented parallel with the device's axis and their field is connected with the fields of magnets in groups 122, 123 on the inner surface of chamber 101.

The device is further equipped with two electromagnets for forming a holding magnetic field. The first electromagnet consists of coil 115, connected across current source I₁, placed behind cathode 101 and coaxially with it, and of core 116 made of soft steel, which is inserted into the central cavity of the first coil 115. The second electromagnet consists of the second coil 117, connected across current source I₂, which is placed behind cathode 101 and coaxially with it around the first coil 115. Hollow core 118, made of soft steel in the shape of a cylindrical annulus, fills the space between the first and the second coil and is connected across plate 119, made of soft steel, with core 116. The whole assembly of cathode 102, the first and the second coil 115 and 117 and magnetic circuit 116, 118, 119 are attached across packing and insulating ring 121 by aid of flange 120 on the edge of the circular cut-out in the vertical wall of chamber 101. For clarity, several components are not shown, such as: the sources of currents I₁ and I₂, the gas filling and pumping systems, packing, insulation, vacuum gauges, means for cooling the cathode, chamber and substrates, and means for heating the substrates. If the process of layer sputtering requires it, the device can also include a movable shutter between the cathode and substrates.

The device functions as follows: Chamber 1 is filled through inlet 8 with a working gas or gas mixture, such as a mixture of argon and nitrogen, to a required overall pressure, p_{T}. A glow discharge is then ignited between cathode 102 and chamber 1, which also serves as anode 103. This discharge is conditional and is influenced by the multipolar magnetic holding field lines of force 113, 114 which enclose the holding space where substrates 105 and holder 104 are accommodated. The lines of force of the multipolar field on the boundary of the holding space change direction at various locations owing to the alternating polarities of magnet groups 122, 123. Therefore, moving from the edge of the holding space to the center, the magnetic field intensity drops quickly. This field pattern applies magnetic pressure to the plasma from the edges toward the center of the holding space, thereby confining a dense plasma.

Magnetic induction on the boundary of the holding space is usually 10 mT to 50 mT or even more; in the middle region containing the substrates, it usually ranges from zero to 2 mT. For perfect plasma holding, it is necessary that from the middle region of the holding space to the anode no channel runs with a lower than minimum magnitude of magnetic induction, which is usually from 1 to 10 mT. If such a channel exists, holding is only partial and the density of the plasma is reduced. Also, the discharge stability may be reduced.

A part of the multipolar magnetic holding field is the magnetic field above cathode 102, formed by coils 115 and 116 and magnetic circuit 116, 118, 119, placed behind cathode 102. Current I₁ of coil 115 from a closed tunnel of lines of force 114 above the cathode and current I₂ of second coil 117 forms a magnetic field, with lines of force emerging from the edge of cathode 102 and connecting with lines of force formed by permanent magnets 111. It is possible to change the shape and intensity of the magnetic field formed by coils 115 and 117 by changing the polarity and magnitude of currents I₁ and I₂, thereby affecting the plasma's holding.

Therefore, a dense plasma results from interaction of the glow discharge between cathode 102 and anode 103 with the multipolar magnetic holding field and is maintained in the holding space. Particles from this plasma, especially electrons and positive ions, impinge on the substrates and can affect the properties of growing layers. If the substrates are electrically conductive, it is possible to apply a voltage U_{S} from source 107 to them and thereby change the kind and energy of bombarding particles, and also change further conditions of the layers' growth. A voltage U_{S} from -20 to -100 V is usually sufficient during layer deposition to achieve such effects. In the case of a higher voltage U_{S}, usually from at least -200 to -1,000 V, it is possible to attain ionic etching of substrates 105.

It is also possible to affect properties of layers by changing the distance between the cathode and the substrates. It was found that in a device in accordance with Figs. 5 and 6 that during titanium sputtering in argon with pressure p_{T} = 0.1 Pa and with constant cathode discharge, the ionization current Iₛ flowing onto substrates with a bias of Uₛ = -100 V varied only ± 10% from its mean value, over cathode-substrate separations ranging from 80 to 220 mm. This is an important advantage of the present method and device, confirming high homogeneity of plasma in the holding space, and can be utilized for affecting properties of layers.

### Examples

The method of layer sputtering is explained below with reference to examples of titanium nitride layers formed in a device represented in Figs. 5 and 6.

### Example 1

Substrates 105 made of high-speed steel placed on holder 104 were heated to a temperature of 500°C at a pressure lower than 10⁻² Pa. Voltage Uₛ = -600 V was applied to substrates 105 for 120 sec and a voltage U_{K} = -500 V was applied to cathode 102 at an argon pressure of 0.09 Pa for ion-cleaning the substrates and the cathode. Next, titanium nitride layers were sputtered for 90 minutes in a mixture of argon and nitrogen at a total pressure of 0.09 Pa with a cathode voltage U_{K} = -600 V and cathode current I_{K} = 5 A. Substrates 5 were placed at a distance 200 mm from cathode 102 and a bias U_{S} = 100 V was applied to them. With coil 115 current I₁ = 0.9 A and coil 117 current I₂ = 4 A, the substrates were bombarded during growth of layers largely by ions from the plasma with total current I_{S} = 610 mA.

A layer prepared as described above had a thickness of 3.2 µm and Vickers microhardness of HV = 2,590 ± 90 kg/mm², which shows a compact microstructure of the layer as well as a bright gold color.

### Example 2

Titanium nitride layers were prepared in the same process as in Example 1, except that the bias on the substrates was U_{S} = -50 V, with texture (220), while other physical properties of layers did not change considerably in comparison with Example 1.

### Example 3

Titanium nitride layers were prepared by the same process as in Example 1, but with source U_{S} disconnected and with floating potential U_{fl} = 31 V with respect to anode 3. The layers had thickness 5.5 µm after a deposition time of 120 min and had a microhardness of HV = 2,070 ± 80 kg/mm², so that they too are compact. X-ray analysis gives the following results: a₁₁₁ = 0.4255 nm, a₂₀₀ = 0.4243 nm; β₁₁₁ = 0.23°, β₂₀₀ = 0.27°, β₂₂₂ = 0.51°; e = (4.0 + 0.5) x 10⁻³, δ = 2.9 GPa. Layers had reduced texture (111) + (200), while relation of corrected reflection intensities I₂₀₀/I₁₁₁ = 1. These properties are unusual compared with titanium nitride coated by other physical methods including conventional sputtering and they show low stresses in the layers and low crystal lattice damage with regard to low energy of bombarding ions and simultaneous bombardment by electrons with sufficient current density. In combination with sufficiently high microhardness, these layers have high adhesion to pads and very useful properties when applied to cutting tools.

### Example 4

Example 4 describes control of layer texture by controlling the magnitude of the floating potential, U_{fl}. The same process was used as in Example 3, but with current I₂ = 10A and I₁ = 2A, the floating potential of substrates, U_{fl}, was increased to -45V and the coated layer had a preferred orientation of (111) with relation I₂₀₀/I₁₁₁ = 0.2. Bias reduction of U_{fl} to -24 V was attained by changing currents I₂ to 3.8A and I₁ to 1.6A and changing the preferred orientation to (200) with relation I₂₀₀/I₁₁₁ = 5. Other layer parameters, such as microhardness, stress and grid parameters did not change substantially. It is expected that layers with controlled texture are important for optimally coating cutting tools, having a wide variety of applications.

The present invention will now further be described with reference to the modifications made relative to the process as described above.

First of all a multiple cathode system is used.

The cathode 2 equipped with the permanent magnet system termed the first cathode forms the magnetron cathode for deposition of the hard material and carries a target consisting of at least one of Ti, Zr, Zi, Hf, TiAl, TiZr, TiNb, and Cr. In use of the apparatus with the first cathode in operation the chamber is filled with a gas supplying nitrogen N or carbon and nitrogen CN to form the actual hard material coating of TiN, TiCN, ZrN, ZiCN, HfN, HfCN, TiAlN, TiAlCN, TiZrN, TiZrCN, TiNbN, TiNbCN, CrN and CrCN. Another one of the cathodes 2, the second cathode, has a target consisting of one of the elements Ta and Nb, and is used for etching of the substrate and for the formation of a transition layer of Ta or Nb. The third cathode 2 has a target identical to the target used on the first cathode. It is also executed as a magnetron cathode, i.e. provided with a magnet arrangement like that of the first cathode.

With this arrangement an etching pretreatment is first carried out using the second cathode with the substrate being maintained at a negative potential bias in the range 1300 to 2000 V, preferably 1500 to 1600 V. A suitable magnet system is used with the second cathode to achieve etching by an arc process.

The process parameters are selected in accordance with the etching values given in the preceding table.

Thereafter a transition layer is formed on the substrate again using the second cathode with the negative substrate bias being reduced to a negative potential bias in the range 1000 to 1400 V.

During this process Ta or Nb ions are implanted into the substrate to form a transition or anchoring layer. Thereafter the magnet system is changed to a magnetron cathode system and a layer of Ta and/or Nb of 0.05 µm to 2 µm thickness is deposited on the transition layer with a negative substrate bias of typically -25 V to -150 V using process parameters similar to those quoted for coating with an imbalanced magnetron in the preceding table. This arc process and the sputtering process are preferably carried out in an atmosphere of argon (at reduced pressure).

Thereafter the first and third cathodes are taken into use, again with process parameters as quoted in the table for an imbalanced magnetron, in order to deposit the actual hard material coating. For this the appropriate gas is added to the chamber.

The second cathode is realised with a movable magnet system in order to change the operation of this cathode from an arc deposition process to a cathode sputtering process.

In a similar manner the apparatus of Figs. 5 and 6 can be modified to execute the process of the present invention.

In the case of Figs. 5 and 6 the single cathode must be replaced by two cathodes, one cathode having a target of the Ta and/or Nb material, i.e. a cathode comprising one of the elements Ta or Nb and a second cathode having a target of the material used for the hard material coating process such as Ti.

By way of example the circular cathode of Figs. 5 and 6 can be subdivided into a central circular cathode in the one material and an outer ring cathode in the other material, each cathode being provided with its own magnet system to generate the tunnel necessary for sputtering operation. It is also necessary to provide respective power supplies to the two cathodes to permit separate operation thereof.

If the one cathode of Ta or Nb is used for ion cleaning, formation of the transition layer and deposition of the 0.05 µm to 2 µm thick Ta or Nb layer by the arc vaporisation process, i.e. is not called upon to deposit the 0.05 µm to 2 µm thick Ta or Nb layer by sputtering then it does not require a separate magnet system for generating a tunnel of field lines but rather a magnet system for arc operation. The magnet system can be designed in accordance with US 5 160 595 so that it is adaptable for both types of operation.

Also four cathodes can be provided. If used for the process of the present invention at least one of the cathodes and preferably two cathodes can be provided with targets made in the Ta or Nb material used for ion etching, formation of the transition zone and deposition of the 0.05 µm to 2 µm layer of Ta or Nb. If two cathodes are used they can be adjacent to one another but are preferably disposed opposite to one another resulting in better uniformity of the coating. The remaining cathodes can be used for the deposition of the hard material coating. Alternatively each of the existing rectangular cathodes can be subdivided into two cathodes, one with a target ofthe Ta or Nb material and the other with a target of the material required for hard material coating.

If the ion etching, formation of the transition zone and deposition of the 0.05 µm to 2 µm layer of Ta or Nb are all effected by the arc vaporisation process then the respective cathodes do not require a tunnel generating magnet system but rather a magnet system suitable for arc vaporisation.

If, however, the deposition of the 0.05 µm to 2 µm layer of Ta or Nb is effected by sputtering then a tunnel generating magnet system is required for the respective cathodes and should be removably arranged as per US patent 5 160 595 in order to permit ion etching and implantation (i.e. formation of the transition zone) by the arc process.

The different types of cathode should be provided, as previously with respective power supplies to permit operation in the different modes.

The ion etching, ion implantation (deposition of the transition zone) and the deposition of the Ta or Nb layer of 0.05 µm to 2 µm thickness is preferably effected in an inert gas typically argon or in an atmosphere of argon and nitrogen although this is not so advantageous because the nitrogen causes embrittlement.

## Claims

1. Method for coating a substrate with a hard material layer consisting of at least one of TiN, TiCN, ZrN, ZrCN, HfN, HfCN, TiAlN, TiAlCN, TiZrN, TiZrCN, TiNbN, TiNbCN, CrN and CrCN by a physical vacuum deposition process,
characterised by the following steps:
(1) an etching pretreatment carried out by arc evaporation using Ta or Nb ions and a high negative substrate bias
(2) followed by the formation of a transition layer at the surface of the substrate by implantation of Ta ions, if Ta ions have been used in step (1) or Nb ions, if Nb ions have been used in step (1), also by arc evaporation, but with a lower substrate bias as compared to (1)
(3) the deposition of a layer of Ta, if Ta has been used in steps (1) and (2) or Nb, if Nb has been used in steps (1) and (2), on top of said transition layer, either by arc evaporation or by sputtering
(4) and finally the deposition by sputtering of the hard material coating.

2. A method in accordance with claim 1, characterised in that the Ta and/or Nb coating has a layer thickness of 0.05 µm to 2 µm.

3. A method in accordance with claim 1, characterised in that in step (3) the deposition of the layer is made by sputtering.

4. A method in accordance with any one of the preceding claims, characterised in that an arc magnetron cathode is used for said sputtering process.

5. A method in accordance with claim 4, characterised in that said arc magnetron cathode is also used as a cathode for said etching process.

6. A method in accodance with any one of the preceding claims, characterised in that a negative bias of -1300 V to -2000 V is applied to said substrate or to said parts during the carrying out of said etching process.

7. A method in accordance with any one of the preceding claims, characterised in that the further coating of the substrates or parts with at least one of TiN, TiCrN, ZrN, ZrCN, HfN, HfCN, TiZrN, TiZrCN, TiNbN, TiNbCN, CrN, CrCN takes place using the droplet-free sputtering technique.

8. A method in accordance with claim 7, characterised in that the further coating preferably takes place using an imbalanced magnetron.

## Patentansprüche

1. Verfahren zum Beschichten eines Substrates mit einer Hartmaterialschicht, die aus zumindest einem aus TiN, TiCN, ZrN, ZrCN, HfN, HfCN, TiAlN, TiAlCN, TiZrN, TiZrCN, TiNbN, TiNbCN, CrN und CrCN besteht, durch einen physikalischen Vakuumabscheidungsprozeß,
gekennzeichnet durch die folgenden Schritte:
(1) eine Ätzvorbehandlung, die durch Lichtbogenverdampfung unter Verwendung von Ta- oder Nb-Ionen und einer hohen negativen Substratvorspannung ausgeführt wird,
(2) gefolgt durch die Bildung einer Übergangsschicht an der Oberfläche des Substrats durch Implantation von Ta-Ionen, wenn Ta-Ionen bei Schritt (1) verwendet worden sind, oder Nb-Ionen, wenn Nb-Ionen bei Schritt (1) verwendet worden sind, auch durch Lichtbogenverdampfung, aber mit einer im Vergleich zu (1) niedrigeren Substratvorspannung,
(3) die Abscheidung einer Schicht aus Ta, wenn Ta bei den Schritten (1) und (2) verwendet worden ist, oder Nb, wenn Nb bei den Schritten (1) und (2) verwendet worden ist, auf der Oberseite der Übergangsschicht entweder durch Lichtbogenverdampfung oder durch Sputtern,
(4) und schließlich die Abscheidung der Hartmaterialbeschichtung durch Sputtern.

2. Verfahren nach Anspruch 1,
dadurch **gekennzeichnet,**
daß die Ta- und/oder Nb-Beschichtung eine Schichtdicke von 0,05 µm bis 2 µm aufweist.

3. Verfahren nach Anspruch 1,
dadurch **gekennzeichnet,**
daß bei Schritt (3) die Abscheidung der Schicht durch Sputtern ausgeführt wird.

4. Verfahren nach einem der vorhergehenden Ansprüche,
dadurch **gekennzeichnet,**
daß eine Lichtbogenmagnetronkathode für den Sputterprozeß verwendet wird.

5. Verfahren nach Anspruch 4,
dadurch **gekennzeichnet,**
daß die Lichtbogenmagnetronkathode auch als eine Kathode für den Ätzprozeß verwendet wird.

6. Verfahren nach einem der vorhergehenden Ansprüche,
dadurch **gekennzeichnet,**
daß eine negative Vorspannung von -1300 V bis -2000 V an das Substrat oder an die Teile während der Ausführung des Ätzprozesses angelegt wird.

7. Verfahren nach einem der vorhergehenden Ansprüche,
dadurch **gekennzeichnet,**
daß die weitere Beschichtung der Substrate oder Teile mit zumindest einem aus TiN, TiCrN, ZrN, ZrCN, HIN, HfCN, TiZrN, TiZrCN, TiNbN, TiNbCN, CrN, CrCN unter Verwendung der tröpfchenfreien Sputtertechnik ausgeführt wird.

8. Verfahren nach Anspruch 7,
dadurch **gekennzeichnet,**
daß die weitere Beschichtung vorzugsweise unter Verwendung eines unausgeglichenen Magnetrons ausgeführt wird.

## Revendications

1. Procédé pour revêtir un substrat d'une couche de matière dure constituée d'au moins l'un des TiN, TiCN, ZrN, ZrCN, HfN, HfCN, TiAlN, TiAlCN, TiZrN, TiZrCN, TiNbN, TiNbCN, CrN et CrCN par un processus de dépôt physique sous vide,
caractérisé par les étapes suivantes :
(1) un prétraitement d'attaque exécuté par évaporation à l'arc en utilisant des ions Ta et Nb et une polarisation négative élevée d'un substrat
(2) suivi par la formation d'une couche de transition à la surface du substrat par l'implantation d'ions Ta, si des ions Ta ont été utilisés dans l'étape (1) ou d'ions Nb, si des ions Nb ont été utilisés dans l'étape (1), également par évaporation à l'arc, mais avec une polarisation de substrat inférieure en comparaison avec (1)
(3) le dépôt d'une couche de Ta, si du Ta a été utilisé dans les étapes (1) et (2), ou de Nb, si du Nb a été utilisé dans les étapes (1) et (2), sur le dessus de ladite couche de transition, soit par évaporation à l'arc, soit par pulvérisation
(4) et finalement le dépôt par pulvérisation du revêtement de matière dure.

2. Procédé selon la revendication 1, caractérisé en ce que le revêtement de Ta et/ou Nb présente une épaisseur de couche de 0,05 µm à 2 µm.

3. Procédé selon la revendication 1, caractérisé en ce que, dans l'étape (3), le dépôt de la couche est réalisé par pulvérisation.

4. Procédé selon l'une quelconque des revendications précédentes, caractérisé en ce qu'une cathode de magnétron à arc est utilisée pour ledit processus de pulvérisation.

5. Procédé selon la revendication 4, caractérisé en ce que ladite cathode de magnétron à arc est également utilisée en tant que cathode pour ledit processus d'attaque.

6. Procédé selon l'une quelconque des revendications précédentes, caractérisé en ce qu'une polarisation négative de -1300 V à -2000 V est appliquée audit substrat ou auxdites parties pendant l'exécution dudit processus d'attaque.

7. Procédé selon l'une quelconque des revendications précédentes, caractérisé en ce que la poursuite du revêtement des substrats ou des parties avec au moins l'un des TiN, TiCrN, ZrN, ZrCN, HfN, HfCN, TiZrN, TiZrCN, TiNbN, TiNbCN, CrN, CrCN a lieu en utilisant la technique de pulvérisation sans gouttelettes.

8. Procédé selon la revendication 7, caractérisé en ce que le revêtement supplémentaire a lieu avantageusement en utilisant un magnétron non équilibré.
